(19) **Europäisches Patentamt / European Patent Office / Office européen des brevets**

(11) **EP 1 586 406 B1**

(12) **EUROPEAN PATENT SPECIFICATION**

(45) Date of publication and mention
of the grant of the patent:
**31.10.2007 Bulletin 2007/44**

(51) Int Cl.:
*B23K 26/06* *(2006.01)*  *B23K 26/08* *(2006.01)*
*B23K 26/38* *(2006.01)*  *B23K 26/40* *(2006.01)*
*H01L 21/78* *(2006.01)*

(21) Application number: **04014434.7**

(22) Date of filing: **19.06.2004**

(54) **Laser processing apparatus with polygon mirror**

Laserbearbeitungsvorrichtung mit einem Polygonspiegel

Dispositif de traitement par laser avec un miroir polygonal

(84) Designated Contracting States:
**AT BE BG CH CY CZ DE DK EE ES FI FR GB GR HU IE IT LI LU MC NL PL PT RO SE SI SK TR**

(30) Priority: **31.03.2004 KR 2004022270**

(43) Date of publication of application:
**19.10.2005 Bulletin 2005/42**

(73) Proprietor: **EO Technics Co.,Ltd.**
**Anyang-si**
**158-050 Gyeonggi-do (KR)**

(72) Inventor: **Han, You-Hie**
**Daejeon-si**
**305-333 (KR)**

(74) Representative: **Eisenführ, Speiser & Partner**
**Patentanwälte Rechtsanwälte**
**Postfach 10 60 78**
**28060 Bremen (DE)**

(56) References cited:
**EP-A- 0 483 569**  **EP-A- 1 080 821**
**US-A- 5 254 833**  **US-A- 5 632 083**
**US-A1- 2002 170 886**  **US-A1- 2003 184 835**
**US-A1- 2003 189 032**

EP 1 586 406 B1

## Description

The present invention relates to a laser processing apparatus with a polygon mirror according to the preamble of claim 1 (see, for example, US-A-5 632 083), capable of processing an object by reflecting a laser beam on the polygon mirror.

## BACKGROUND ART

Since apparatuses using a laser beam have more advantage for cutting silicon wafers than other mechanical apparatuses, various studies about them have been advanced. One of the most advanced apparatus for cutting a wafer is an-apparatus using a laser beam guided by ejected water from a high-pressure water jet nozzle.

A wafer cutout apparatus employing the high-pressure water jet nozzle irradiates a laser beam on a wafer with ejecting water through a high-pressure jet nozzle. As the water jet nozzle is easily worn away due to the high pressure, the nozzle has to be changed periodically.

The periodic change of the high-pressure jet nozzle causes inconveniences in conducting the wafer cutout process. It also results in lower productivity and higher manufacturing cost.

Also, since it is difficult for a conventional wafer cutout apparatus to offer fine line width, there are problems in adopting the apparatus to high-precision process.

Meanwhile a wafer cutout process using only a laser beam brings about a recasting effect which means vapors evaporated by a laser beam are deposited on cutout sides of wafer. It interrupts a wafer cutout process.

US-A-5 632,083 discloses a lead frame fabricating method and apparatus for fabricating lead frames of fine pattern at a high speed. For cutting a metal plate a laser beam emitted in the form of pulses and having a circular section is converted by a beam section transformer into a laser beam having an elongate elliptic section which is rotated on its optical axis by a beam rotating device so that the lengthwise direction of the section of the laser beam is coincident with the lengthwise direction of each of inner leads. An optical axis of a laser beam is revolved along each of concentric paths around the original optical axis given when the laser beam is emitted. In an embodiment a polygon mirror is disposed between the beam section transformers and the beam rotating device as focus position changing means.

US 2003/0184835 A1 discloses a multi-beam polygon scanning system wherein two or more light beams impinge at different incident angles on a polygon facet and are sequentially used for scanning the surface of a substrate as the polygon is rotated.

US 5,254,833 discloses a brittle material cleavage-cutting apparatus comprising a placing stand for holding a brittle material and beam scanning device for deflecting a laser beam from a laser source so that a brittle material placed on the placing stand is scanned along a planned cleavage-cutting line. By the beam scanning device the laser-beam irradiation position on the brittle material is repeatedly moved in short cycles along the planned cleavage-cutting line.

## DISCLOSURE OF INVENTION

To solve the aforementioned problems, an object of the present invention is to provide a laser processing apparatus with a polygon mirror, capable of processing an object such as a wafer precisely by preventing a recasting effect without changing any additional devices.

According to the invention, a laser processing apparatus is provided as defined in claim 1.

## BRIEF DESCRIPTION OF THE DRAWINGS

FIGs. 1A through 1C are schematic diagrams illustrating conceptual features of a laser processing apparatus employing a polygon mirror in accordance with the present invention.
FIG. 2 is a schematic diagram illustrating a conceptual feature of the laser processing apparatus employing the polygon mirror in accordance with the present invention.
FIG. 3 is a diagram illustrating overlapping laser beams in accordance with the present invention.
FIG. 4 is a diagram illustrating an exemplary embodiment of the laser processing apparatus with the polygon mirror in accordance with the present invention.
FIG. 5 is a diagram illustrating another embodiment of the laser processing apparatus with the polygon mirror in accordance with the present invention.
FIG. 6 is a flow chart explaining a procedure of processing an object in accordance with the present invention.
FIG. 7 is a schematic diagram illustrating a configuration of wafer processing by the laser processing apparatus with the polygon mirror in accordance with the present invention.

## DETAILED DESCRIPTION OF THE INVENTION

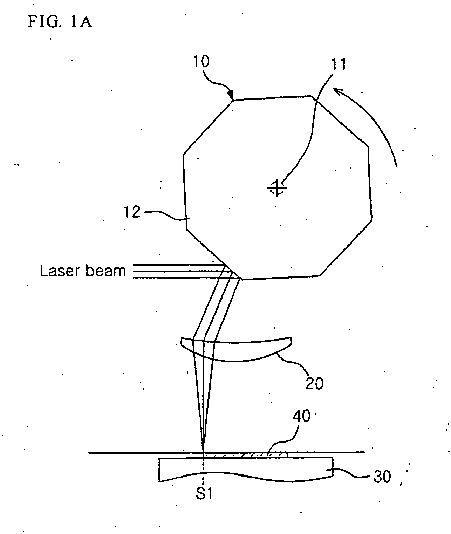

FIGs. 1A through 1C are schematic diagrams illustrating a conceptual feature of a laser processing apparatus employing a polygon mirror.

As shown in FIGs. 1A through 1C, the laser processing apparatus is comprised of a polygon mirror 10 having a plurality of reflection planes and rotating at an axis 11, and a telecentric f-theta lens 20 condensing laser beams reflected from the reflection planes thereon. The lens 20 is installed in parallel with a stage 30 on which a wafer 40 to be cut out is settled, in order to condense laser beams reflected from the reflection planes thereon. Thus, a laser beam condensed on the lens 20 is irradiated to the wafer in perpendicular, which enables the wafer 40 (e.g., a semiconductor wafer) to be processed (able to be cut out) in a predetermined shape.

While the lens 20 may be composed of a couple groups of lenses, this embodiment uses a single lens in convenience on description.

FIGs.1A through 1C illustrate the features that a laser beam reflected from the reflection plane 12 is applied to the wafer 40 being condensed through the lens 20 while the polygon mirror 10 is rotating in an anti-clockwise direction at the axis 11.

Referring to FIG. 1A, laser beams are reflected from the beginning part of the reflection plane 12 in accordance with the rotation of the polygon mirror 10, and then incident on a left end of the lens 20. The reflected laser beams are condensed on the lens 20 and irradiated to a predetermined position S 1 of the wafer 40 in perpendicular.

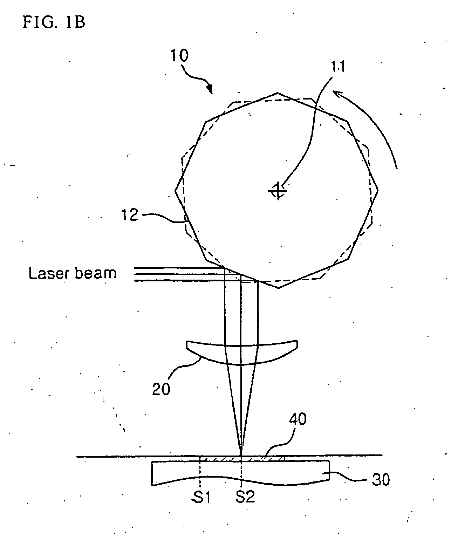

Referring to FIG. 1B, when the polygon mirror 10 more advances its rotation to reflect the laser beams on a central part of the reflection plane 12, the reflected laser beams are incident on a central position of the lens 20 and condensed on the lens 20. The condensed laser beam on the lens 20 is irradiated on a predetermined position S2 of the wafer 40 in perpendicular.

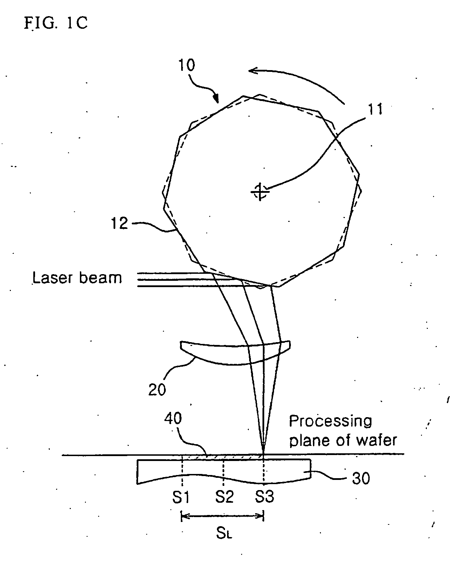

Referring to FIG. 1C, when the polygon mirror 10 further advances its rotation, more than the case of FIG. 1B, to reflect the laser beams on a rear part of the reflection plane 12, the reflected laser beams on the rear part are incident on a right end of the lens 20 and condensed on the lens 20. The condensed laser beam on the lens 20 is irradiated on a predetermined position S3 of the wafer 40 in perpendicular.

As aforementioned throughout FIGs.1 A to 1C, the laser beams are applied to the predetermined positions S1 to S3 on the wafer 40 in accordance with the anti-clockwise rotation of the polygon mirror 10. The distance from S1 to S3 is regarded to as a scanning length $S_L$ that means an interval to irradiate the wafer 40 by the reflection plane 12 along the rotation of the polygon mirror 10. A reflection angle of the laser beam, which is formed by the beginning and rear parts of the reflection plane 12 is referred to as a scanning angle $\theta$.

Hereinafter, the theoretical feature will be described in more detail.

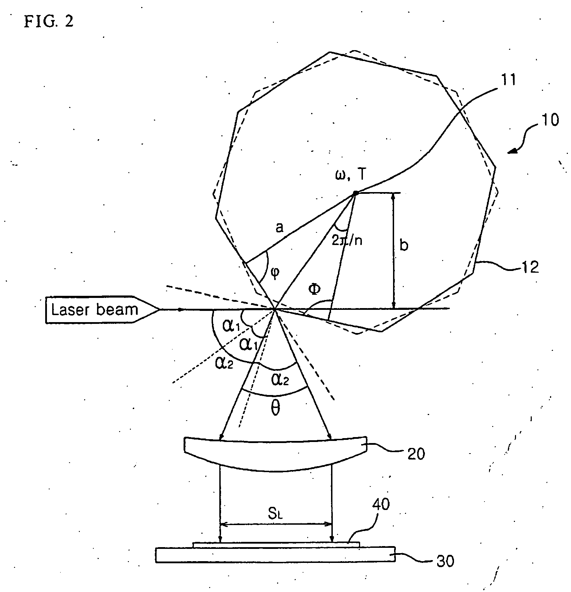

FIG. 2 illustrates a schematic configuration of the laser processing apparatus employing the polygon mirror in accordance with the present invention.

Referring to FIG. 2, the polygon mirror 10 constructed with $n$ - numbered reflection planes rotates in a constant speed at the axis 11 in an angular velocity of $\omega$ and a cycle period $T$. A laser beam incident thereon is reflected from the reflection plane 12 and irradiated on the wafer 40 through the lens 20.

In the polygon mirror 10 having the n-numbered reflection planes 12, the scanning angle $\theta$ of the laser beam when one of the reflection planes 12 is rotating is summarized as the following Equation 1.

$$[\text{Equation 1}]$$

$$\theta = 2(\alpha_2 - \alpha_1)$$

$$\alpha_1 = \phi + \psi - \frac{\pi}{2}$$

$$\alpha_2 = \phi + \psi - \frac{\pi}{2} + \frac{2\pi}{n}$$

$$\therefore \theta = \frac{4\pi}{n}$$

From the Equation 1, it can be seen that the scanning angle $\theta$ is twice the central angle $(\frac{2\pi}{n})$ on the reflection

plane 12 of the polygon mirror 10. Therefore, the scanning length $S_L$, that is a range of irradiation on the wafer 40 by the reflected laser beam applied from the reflection plane 12 of the polygon mirror 10, is determined by a morphological characteristic of the lens 20, as follows.

[Equation 2]

$$S_L = f \times \theta = \frac{4\pi f}{n}$$

$S_L$ : Scanning length
$f$ : Focal distance
$\theta$ : Scanning angle

According to Equation 2, a laser beam reflected from each of the reflection planes 12 of the polygon mirror 10 while the polygon mirror 10 is rotating is irradiated on the wafer 40 by the length of $S_L$. In other words, the scanning length $S_L$ of a laser beam irradiated on the wafer 40 in accordance with the rotation of the polygon mirror 10 is obtained from a product of the focal length $f$ and the scanning angle $\theta$ of the laser beam reflected from the reflection plane 12 of the polygon mirror 12.

By the way, as the polygon mirror 10 has the $n$-numbered reflection planes 12, an n-times scanning with the scanning length $S_L$ is available in every one cycle of rotation of the polygon mirror 10. That is, a laser beam irradiated on the wafer 40 is applied to the wafer 40 by the scanning length $S_L$, overlapping in the wafer 40 by the number of the reflection planes 12 of the polygon mirror 10 when the polygon mirror 10 rotates one time. A scanning frequency during a unit time interval (e.g., one second) may be obtained from the following Equation 3.

[Equation 3]

$$\text{Scanning frequency} = \frac{\omega n}{2\pi} = \frac{n}{T}$$

$\omega$ : Angular velocity of the polygon mirror
$T$ : Cycle period of the polygon mirror

From Equation 3, in the condition with the $n$-numbered reflection planes 12 on the polygon mirror 10, it is possible to adjust the scanning frequency by controlling the cycle period or the angular velocity of the polygon mirror 10. In other words, the scanning length $S_L$ is controllable in desired times of overlapping by varying the cycle period $T$ or the angular velocity $\omega$ of the polygon mirror 10.

If the angular velocity $\omega$ of the polygon mirror 10 is constant, a relative wafer 40 scanning speed of the laser beam reflected from the polygon mirror 10 is enhanced by transferring the stage 30, on which the wafer 40 is settled, toward the direction reverse to the rotating direction of the polygon mirror 10. In other words, when the stage 30 is transferred to the direction reverse to the rotating direction of the polygon mirror 10, a wafer 40 scanning speed of the laser beam $S_L$ gets faster compared to the wafer 40 scanning speed of the laser beam when the stage 30 is standing without moving.

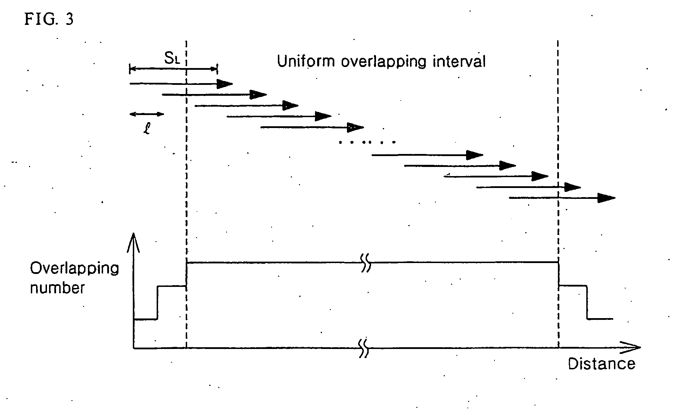

Such overlaps with the scanning length $S_L$, as illustrated in FIG. 3, progress along the direction reverse to the transfer direction of the stage 30 where the wafer 40 is settled. As a result, the wafer 40 on the stage 30 is scanned and cut out by the laser beam along the direction reverse to the transfer direction of the stage 30. During this, the scanning lengths $S_L$ continuously overlap from each other in a uniform range, in which the number of overlapping times may be adjustable by controlling the transfer speed of the stage 30.

Provided that a migration distance by the scanning length $S_L$ is $l$ along the transfer of the stage 30, an overlapping degree $N$ of the scanning length may be represented in $S_L/l$.

The migration distance $l$ denotes a dimension by which the stage 30 with velocity $v$ moves for a time until one of the reflection planes 12 completes to rotate, being summarized in the following Equation 4. The overlapping degree $N$ is represented in Equation 5.

[Equation 4]

$$l = \frac{v}{\frac{n}{T}} = \frac{vT}{n} = \frac{2\pi v}{n\omega}$$

[Equation 5]

$$\text{Overlapping degree } (N) = \frac{S_L}{l} \doteq \frac{4\pi f}{vT} = \frac{2\omega f}{v}$$

By summarizing the aforementioned description, the angular velocity ω of the polygon mirror 10 with the overlapping degree $N$ while the wafer 40 is cutting out in the velocity $v$ results in Equation 6 as follows.

[Equation 6]

$$\omega = \frac{Nv}{2f}$$

As represented in Equation 6, the angular velocity is obtained by dividing a product of the overlapping degree $N$ of the laser beam and the cutout velocity $v$ with a double value of the focal length $f$ of the lens 20, where the cutout velocity $v$ corresponds to the transfer speed of the stage 30 settling the wafer 40 thereon.

While this embodiment uses a polygon mirror shaped with eight reflection planes (i.e., $n = 8$) in eight corners, other polygonal patterns may be available in modification under the scope of the present invention.

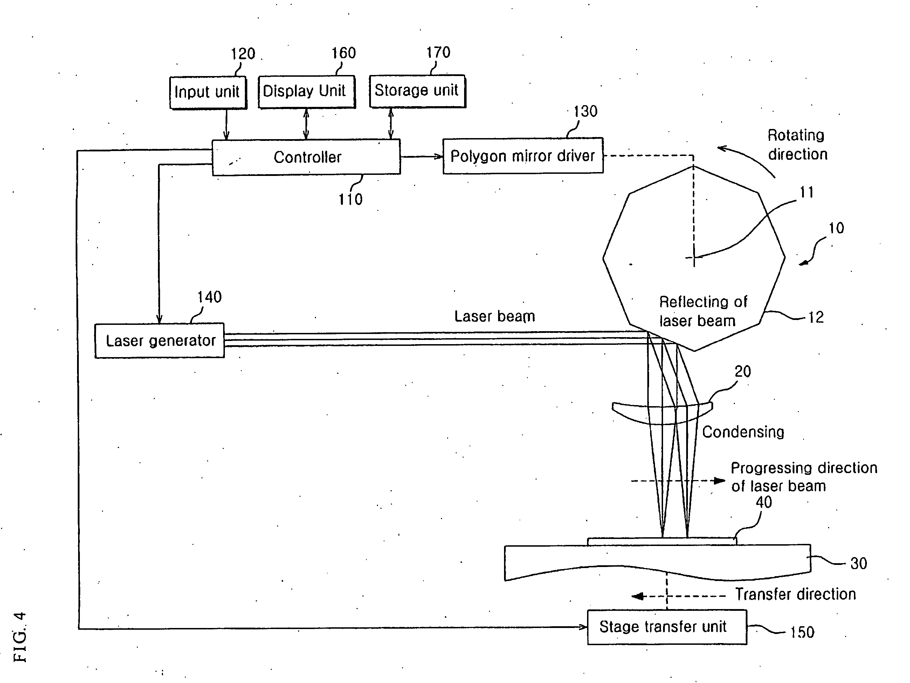

FIG. 4 illustrates an exemplary embodiment of the laser processing apparatus with the polygon mirror.

Referring to FIG. 4, the laser processing apparatus with the polygon mirror according to the present invention is comprised of a controller 110 for conducting an overall operation, an input unit 120 for entering control parameters and control commands, a polygon mirror driver 130 for actuating the polygon mirror 10, a laser generator 140 for emitting laser beams, a stage transfer unit 150 for transferring the stage 30, on which the wafer 40 is settled, in a predetermined direction, a display unit 160 for informing the external users of current operating states, and a storage unit 170 for storing data relevant thereto.

The polygon mirror driver 130 includes a plurality of the reflection plane 12, being configured to make the polygon mirror 10, which has multiple planes, rotate in a predetermined velocity at the axis 11. The polygon mirror 10 uniformly rotates at the axis 11 in the predetermined velocity by means of a motor (not shown) under control of the controller 110.

The laser generator 140 is configured to emit the laser beams to process the wafer 40 as an object settled on the stage 30, generating ultraviolet-ray laser beams under control of the controller 110 in this embodiment.

The stage transfer unit 150 is configured to transfer the stage 30, on which the wafer 40 as an object to be treated is settled, in a predetermined velocity.

In the structure of the laser processing apparatus, laser beams emitted from the laser generator 140 are incident on the polygon mirror 10 under control of the controller 110. The laser beams applied to the polygon mirror 10 are reflected toward the lens 20 from the reflection planes 12, which are rotating by the polygon mirror driver 130, within the range of the scanning angle θ. The laser beams reflected from the reflection planes 12 are condensed on the lens 20, and the condensed laser beam is irradiated on the wafer 40 in perpendicular.

The laser beam being irradiated on the wafer 40 while one of the reflection planes 12 of the polygon mirror 10 is rotating migrates by the scanning length $S_L$ along the direction reverse to the transfer direction of the stage 30.

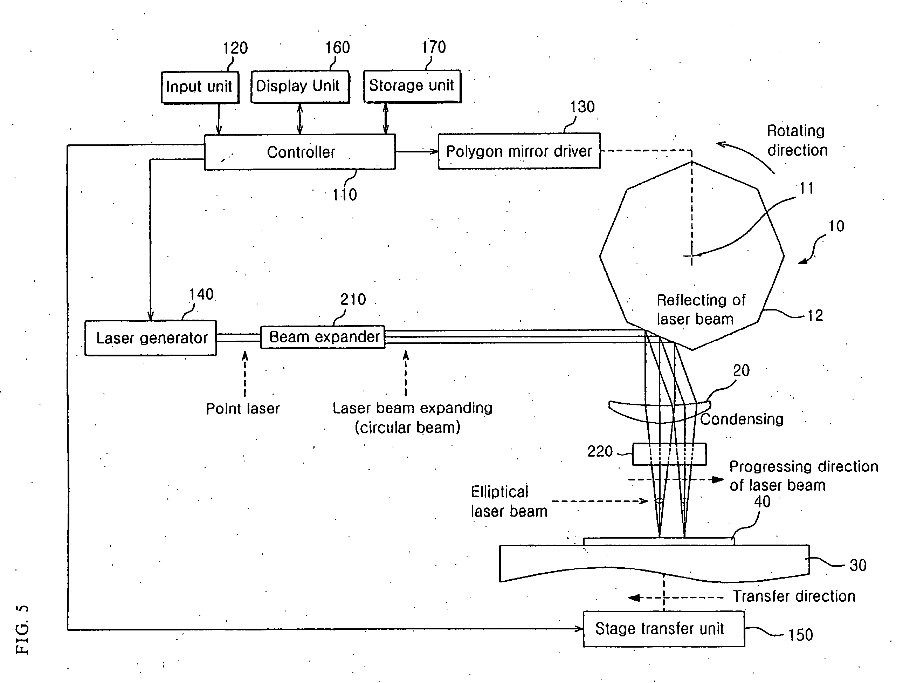

FIG. 5 illustrates another embodiment of the laser processing apparatus with the polygon mirror in accordance with the present invention.

Referring to FIG. 5, the laser processing apparatus with the polygon mirror, in accordance with another embodiment of the present invention, is basically comprised of a controller 110 for conducting an overall operation, an input unit 120 for entering control parameters and control commands, a polygon mirror driver 130 for actuating the polygon mirror 10, a laser generator 140 for emitting laser beams, a stage transfer unit 150 for transferring the stage 30, on which the wafer 40 is settled, in a predetermined direction, a display unit 160 for informing the external users of current operating states, and a storage unit 170 for storing data relevant thereto.

These structures of FIG. 5 are as same as those of FIG. 4. But, the laser processing apparatus with the polygon mirror in FIG. 5 is further comprised of a beam expander 210 for enlarging diameters of pointing laser beams emitted from the laser generator 140 and then applying the enlarged laser beams to the polygon mirror 10, and a beam transformer 220 for converting the laser beam, which is condensed on the lens 20 after being reflected from the polygon mirror 10, into an elliptical pattern. At this time the beam transformer 220 may be easily implemented by employing a cylindrical lens.

The enlarged laser beams incident on the polygon mirror 10 are reflected toward the lens 20 on the reflection planes 12 of the polygon mirror 10 within the range of the scanning angle θ. The laser beam reflected from the reflection planes 12 is condensed on the lens 20, converted into an elliptical pattern by the beam transformer 220 in sectional view, and then irradiated on the wafer 40 in perpendicular.

As the irradiated laser beam has elliptical sectional pattern, a long diameter of the elliptical section corresponds to a direction of cutout processing while a short diameter of the elliptical section corresponds to a width of cutout processing.

When one of the reflection planes 12 is rotating on the axis 11, the laser beam irradiated on the wafer 40 is shifted as the scanning length $S_L$ along the direction reverse to the transfer direction of the stage 30.

Hereinafter, it will be described in detail about a procedure of processing an object (i.e., the wafer 40) by means of the laser processing apparatus with the polygon mirror shown in FIG. 5.

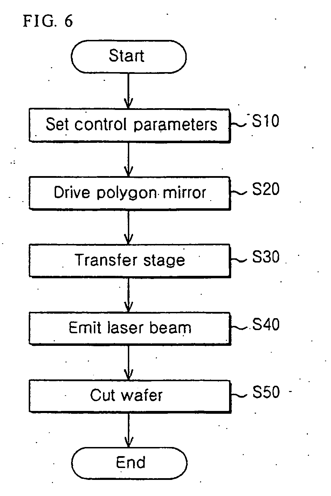

FIG. 6 is a flow chart explaining a procedure of processing an object, in accordance with the present invention.

Referring to FIG. 6, in order to process the wafer, i.e., to cut the wafer 40 out, first control parameters for a rotation velocity of the polygon mirror 10 and a transfer velocity of the stage 30 in the input unit 120 are established, in accordance with a type of the wafer 40 to be processed (step S10). Such setting operations may be simply carried out by retrieving information menus from the storage unit 170 after registering the information, that has been preliminarily designed for wafer types and processing options (e.g., cutting, grooving, and so on), in the storage unit 170.

After completing the establishment for the control parameters, the controller 110 enables the polygon mirror driver 130 to rotate the polygon mirror 10 in a rotation velocity that has been predetermined at the step S10 (step S20), and also enables the stage transfer unit 150 to transfer the stage 30 in a predetermined velocity (step S30). At this point the controller 110 makes the laser generator 140 emit the laser beam (step S40).

Then, the laser beam emitted from the laser generator 140 is incident on the polygon mirror 10 with being enlarged in its sectional diameter after passing through the beam expander 210. The laser beam incident on the polygon mirror 10 is reflected from the reflection plane 12 of the polygon mirror 10 rotating at the axis 11, toward the lens 20 within the range of the scanning angle θ.

The lens 20 condenses the laser beam reflected from the polygon mirror 10, and the condensed laser beam on the lens 20 is irradiated on the wafer 40 in perpendicular after being converted into an elliptical pattern in sectional view by the beam transformer 220. The laser beam finally applied to the wafer 40 has a elliptical sectional pattern in which the long diameter accords to the cutout direction of the wafer 40, i.e., a progressing direction of processing, which extends an irradiation range of the laser beam over the wafer 40 a time, while the short diameter corresponds to a cutout thickness, i.e., a cutout width of processing.

During the procedure, as the polygon mirror 10 rotates with a constant speed, a plurality of the laser beam irradiated on the wafer 40 are overlapped in predetermined times by a plurality of the scanning length $S_L$ over the wafer 40.

In addition, as the stage 30 settling the wafer 40 thereon is transferred in the direction reverse to the rotation direction of the polygon mirror 10, a relative speed of irradiation with the scanning length by the laser beam on the wafer 40 becomes faster which makes the wafer cutout process efficient (step S50).

On the other hand, the laser beam emitted from the laser generator 140 is directly irradiated on the wafer 40 when it skips the steps of the beam expander 210 and the beam transformer 220.

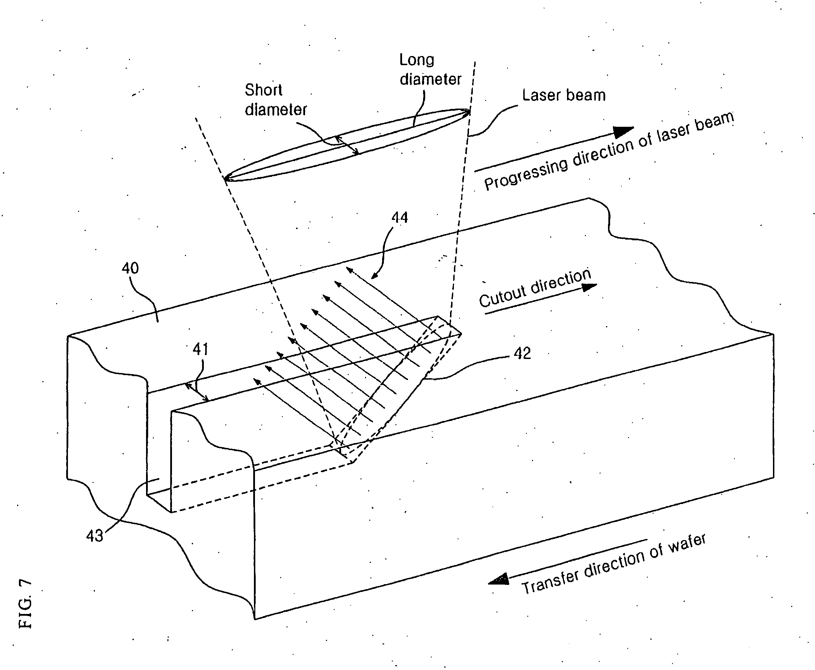

FIG. 7 illustrates a configuration of processing the wafer 40 by the laser processing apparatus with the polygon mirror in accordance with the present invention.

As aforementioned, the laser beam enlarged with its sectional diameter after passing through the beam expander 210 is incident on the polygon mirror 10. The laser beam incident on the polygon mirror 10 is reflected within the range of the scanning angle θ toward the lens 20 on the reflection plane 12 of the polygon mirror 10 that is rotating. The lens 20 condenses the laser beam. The laser beam condensed on the lens 20 is shaped into a sectional elliptical pattern by the beam transformer 220 and then irradiated on the wafer 40.

During this, as the laser beam irradiated on the wafer 40 has the sectional elliptical pattern, the long diameter of the ellipse is associated with a progressing direction on the wafer 40 by the laser beam while the short diameter of the ellipse is associated with a cutout width on the wafer 40 by the laser beam.

As illustrated in FIG. 7, the elliptical laser beam irradiated on the wafer 40 is progressing along the direction of its long diameter, accompanying with the cutout width by its short diameter. In other words, the cutout width 41 of the wafer 40 is adjustable by controlling the short diameter of the elliptical section of the laser beam, which is established by the beam transformer 220.

During the irradiation on the wafer 40 by the laser beam, evaporation may be occurred at places on which the laser beam is irradiated. However, the progressing direction of the laser beam is reverse to the transfer direction of the wafer 40, as aforementioned, so that the relative scanning speed of the laser beam becomes faster and the long diameter of the laser beam is arranged to the processing direction (i.e., the cutout direction). As a result, a cutout section 42 has a slope throughout the cutout process, by which vapors escaping from the wafer material due to the irradiation of the laser beam are easily discharged without depositing on the cutout plane 42 during the process.

Moreover, since the rapid overlapping with the laser beam along the processing direction makes the cutout portion of the wafer 40 be swiftly evaporated, the wafer processing is carried out easily without such as a recasting effect for which vapors from the wafer material are deposited on the cutout wall 43 of the wafer 40.

Although the aforementioned embodiments is exemplarily describes as being applicable to processing a semiconductor wafer, the present invention is also available to processing other substrates or boards such as plastics, metals, and so on.

As described above, the laser processing apparatus with the polygon mirror in accordance with the present invention needs not any change of additional devices because a laser beam is enough to perform the cutout process, which enables the process to be rapidly carried out in easy and efficiency. Furthermore, since the present invention provides an efficient technique to able to control the cutout width by adjusting the short diameter of the elliptical laser beam and to prevent a recasting effect that causes vapors escaping from an object to be cut out, it is advantageous to processing a wafer in highly precise operations, as well as normal objects.

Although the present invention has been described in connection with the embodiment of the present invention illustrated in the accompanying drawings, it is not limited thereto. It will be apparent to those skilled in the art that various substitution, modifications and changes may be thereto without departing from the scope of the invention as defined in the appended claims.

**Claims**

1. A laser processing apparatus with a polygon mirror (10) for processing an object (40) by a laser beam, comprising:

   a laser generator (140) for emitting the laser beam;
   a polygon mirror (10) constructed of a plurality of reflection planes (12) that reflect the laser beam, which is emitted from the laser generator (140), thereon while rotating on an axis (11);
   a lens (20) for condensing the laser beam reflected on the polygon mirror (10) and irradiating the laser beam on the object (40);
   a stage (30) for settling the object;

   **characterized by**
   a stage transfer unit (150) for transferring the stage (30) toward a predetermined direction;
   a controller (110) for controlling the stage transfer unit (150); and
   a polygon mirror driver (130) for rotating the polygon mirror (10), in a constant speed to make the reflection planes (12) revolve with a predetermined angular velocity,
   wherein the controller (110) is so contracted to control the polygon mirror driver (130) and the stage transfer unit (150) to transfer the stage (30) reverse to a rotating direction of the polygon mirror (10) and reverse to the progression direction of the layer beam.

2. The laser processing apparatus with the polygon mirror (10) according to claim 1, which further comprises a beam transformer (220) for converting a sectional pattern of the laser beam condensed on the lens (20) into an ellipse.

3. The laser processing apparatus with the polygon mirror (10) according to claim 2, wherein the controller (110) controls the beam transformer (220) to convert the laser beam to be shaped with the sectional pattern as the ellipse whose long diameter is arranged along a processing direction and then irradiates the converted laser beam on the object (40).

4. The laser processing apparatus with the polygon mirror (10) according to claim 5, wherein the controller (110) controls a short diameter of the elliptical section of the converted laser beam for adjusting the processing width by the laser beam.

5. The laser processing apparatus with the polygon mirror (10) according to any one of the preceding claims, wherein the object (40) processed by the laser beam is a wafer.

6. The laser processing apparatus with the polygon mirror (10) according to any one of the preceding claims, which further comprises a beam expander (210) for enlarging a sectional diameter of the laser beam emitted from the laser generator (140), the enlarged laser beam being condensed on the lens (20) after reflected on the polygon mirror (10) and being incident on the beam transformer (220).

7. The laser processing apparatus with the polygon mirror (10), according to claim 5, wherein the lens (20) condenses the laser beam thereon and then irradiates the laser beam on the wafer (40) in perpendicular.

8. The laser processing apparatus with the polygon mirror (10) according to claim 5, wherein the controller (110) controls a scanning length of the laser beam applied to the wafer (40) by one of the reflection planes (12) in accordance with the rotation of the polygon mirror (10) by the product of a focal distance of the lens (20) and a scanning angle of the laser beam reflected from the reflection planes (12) of the polygon mirror (10).

9. The laser processing apparatus with the polygon mirror (10) according to claim 8, wherein the controller (110) controls the scanning angle of the laser beam to be a reflection angle formed by the beginning and rear parts of the reflection plane (12).

10. The laser processing apparatus with the polygon mirror (10) according to claim 5, wherein the laser beam reflected from the reflection plane (12) in accordance with the rotation of the polygon mirror (10) is irradiated on the wafer (40) being overlapped in a predetermined number and the controller (110) controls the predetermined number of overlapping by adjusting an angular velocity of the polygon mirror (10) while keeping a transfer velocity of the stage (30) constant.

11. The laser processing apparatus with the polygon mirror (10) according to claim 5, wherein the laser beam reflected from the reflection plane (12) in accordance with the rotation of the polygon mirror (10) is irradiated on the wafer (40) being overlapped in a predetermined number and the controller (110) controls the predetermined number of overlapping by adjusting a transfer velocity of the stage (30) while keeping an angular velocity of the polygon mirror (10) constant.

**Patentansprüche**

1. Laserbearbeitungsvorrichtung mit einem Polygonspiegel (10) zum Bearbeiten eines Objektes (40) mit einem Laserstrahl, mit:

   einem Lasergenerator (140) zum Emittieren des Laserstrahls,
   einem Polygonspiegel (10), der aus einer Mehrzahl von Reflektionsflächen (12) aufgebaut ist, die den Laserstrahl reflektieren, der von dem Lasergenerator (140) emittiert wird, während diese um eine Achse (11) rotieren,
   einer Linse (20) zum Bündeln des von dem Polygonspiegel (10) reflektierten Laserstrahls und zum Einstrahlen des Laserstrahls auf das Objekt (40),
   einer Bühne (30) zum Absetzen des Objektes,

   **gekennzeichnet durch**
   eine Bühnentransfereinheit (150) zum Transferieren der Bühne in einer vorbestimmten Richtung,
   einen Controller (110) zum Steuern der Bühnentransfereinheit (150), und
   einen Polygonspiegeltreiber (130) zum Rotieren des Polygonspiegels (10) mit einer konstanten Geschwindigkeit, um die Reflektionsflächen (12) mit einer vorbestimmten Winkelgeschwindigkeit umlaufen zu lassen,
   wobei der Controller (110) derart aufgebaut ist, um den Polygonspiegeltreiber (130) und die Bühnentransfereinheit (150) zu steuern, um die Bühne (30) entgegen einer Rotationsrichtung des Polygonspiegels (110) und entgegen der Ablaufrichtung des Laserstrahl zu transferieren.

2. Laserbearbeitungsvorrichtung mit dem Polygonspiegel (10) nach Anspruch 1, ferner umfassend einen Strahlwandler (220) zum Umwandeln eines Abschnittsmusters des Laserstrahls, der an der Linse (20) gebündelt ist, in eine Ellipse.

3. Laserbearbeitungsvorrichtung mit dem Polygonspiegel (10) nach Anspruch 2, wobei der Controller (110) den Strahlumwandler (220) steuert, um den Laserstrahl so umzuwandeln, dass dieser mit dem Abschnittsmuster als der Ellipse so geformt ist, dass deren Hauptachse entlang einer Fortschrittsrichtung ausgerichtet ist, und dann den umgewandelten Laserstrahl auf das Objekt (40) einstrahlt.

4. Laserbearbeitungsvorrichtung mit dem Polygonspiegel (10) nach Anspruch 5, wobei der Controller (110) eine Nebenachse des elliptischen Abschnitts des umgewandelten Laserstrahls zum Justieren der Verarbeitungsbreite durch den Laserstrahl steuert.

5. Laserbearbeitungsvorrichtung mit dem Polygonspiegel (10) nach einem der vorstehenden Ansprüche, wobei das Objekt (40), das durch den Laserstrahl bearbeitet wird, ein Wafer ist.

6. Laserbearbeitungsvorrichtung mit dem Polygonspiegel (10) nach einem der vorstehenden Ansprüche, ferner mit einem Strahlausdehner (210) zum Vergrößern eines Abschnittsdurchmessers des Laserstrahls, der von dem Lasergenerator (140) emittiert wird, wobei der vergrößerte Laserstrahl an der Linse (20) gebündelt wird, nachdem er an dem Polygonspiegel (10) reflektiert wurde, und auf den Strahlumformer (220) gerichtet wird.

7. Laserbearbeitungsvorrichtung mit dem Polygonspiegel (10) nach Anspruch 5, wobei die Linse (20) den Laserstrahl daran bündelt und dann den Laserstrahl senkrecht auf den Wafer (40) einstrahlt.

8. Laserbearbeitungsvorrichtung mit dem Polygonspiegel (10) nach Anspruch 5, wobei der Controller (110) eine Abtastlänge des Laserstrahls, der auf den Wafer (40) gerichtet ist, durch eine der Reflektionsflächen (12) entsprechend mit der Rotation des Polygonspiegels (10) durch das Produkt einer Brennweite der Linse (20) und einem Abtastwinkel des Laserstrahls, der von den Reflektionsflächen (12) des Polygonspiegels (10) reflektiert ist, steuert.

9. Laserbearbeitungsvorrichtung mit dem Polygonspiegel (10) nach Anspruch 8, wobei der Controller (110) den Abtastwinkel des Laserstrahls steuert, um ein Reflektionswinkel zu sein, der durch die Anfangs- und Endteile der Reflektionsfläche (12) gebildet ist.

10. Laserbearbeitungsvorrichtung mit dem Polygonspiegel (10) nach Anspruch 5, wobei der Laserstrahl, der von der Reflektionsfläche (12) reflektiert wird, entsprechend der Rotation des Polygonspiegels (10) auf den Wafer (40) eingestrahlt wird, wobei er in einer vorbestimmten Anzahl überlappt wird, und wobei der Controller (110) die vorbestimmte Anzahl von Überlappungen durch Justieren einer Winkelgeschwindigkeit des Polygonspiegels (10) während eines Konstant-Haltens einer Transfergeschwindigkeit der Bühne (30) steuert.

11. Laserbearbeitungsvorrichtung mit dem Polygonspiegel (10) nach Anspruch 5, wobei der Laserstrahl, der von der Reflektionsfläche (12) reflektiert wird, entsprechend der Rotation des Polygonspiegels (10) auf den Wafer (40) eingestrahlt wird, wobei er in einer vorbestimmten Anzahl überlappt wird, und wobei der Controller (110) die vorbestimmte Anzahl von Überlappungen durch Justieren einer Transfergeschwindigkeit der Bühne (30) während eines Konstant-Haltens einer Winkelgeschwindigkeit des Polygonspiegels (10) steuert.

**Revendications**

1. Appareil de traitement au laser avec un miroir polygonal (10) destiné à traiter un objet (40) au moyen d'un faisceau laser, comprenant :

un générateur de laser (140) destiné à émettre le faisceau laser ;
un miroir polygonal (10) construit à partir d'une pluralité de plans de réflexion (12) qui réfléchissent le faisceau laser, qui est émis depuis le générateur de laser (140), sur celui-ci pendant qu'il effectue une rotation sur un axe (11) ;
une lentille (20) destinée à condenser le faisceau laser réfléchi sur le miroir polygonal (10) et irradier le faisceau laser sur l'objet (40) ;
une platine (30) destinée à déposer l'objet ;

**caractérisé en ce qu'**il comprend une unité de transfert (150) de platine destinée à transférer la platine (30) vers une direction prédéterminée ;
un dispositif de commande (110) destiné à commander l'unité de transfert (150) de platine ; et
un dispositif d'entraînement (130) de miroir polygonal destiné à mettre en rotation le miroir polygonal (10) à une vitesse constante pour faire tourner les plans de réflexion (12) selon une vitesse angulaire prédéterminée,
dans lequel le dispositif de commande (110) est construit de façon à commander le dispositif d'entraînement (130) de miroir polygonal et l'unité de transfert (150) de platine pour transférer la platine (30) à l'inverse d'une direction de rotation du miroir polygonal (10) et à l'inverse de la direction de progression du faisceau laser.

**2.** Appareil de traitement au laser avec le miroir polygonal (10) selon la revendication 1, qui comprend en outre un dispositif de transformation (220) de faisceau destiné à convertir un motif en coupe du faisceau laser condensé sur la lentille (20) en une ellipse.

**3.** Appareil de traitement au laser avec le miroir polygonal (10) selon la revendication 2, dans lequel le dispositif de commande (110) commande le dispositif de transformation de faisceau (220) pour convertir le faisceau laser à former avec le motif en coupe sous la forme de l'ellipse dont un long diamètre est agencé le long d'une direction de traitement puis irradie le faisceau laser converti sur l'objet (40).

**4.** Appareil de traitement au laser avec le miroir polygonal (10) selon la revendication 5, dans lequel le dispositif de commande (110) commande un court diamètre de la section elliptique du faisceau laser converti pour ajuster la largeur du traitement au moyen du faisceau laser.

**5.** Appareil de traitement au laser avec le miroir polygonal (10) selon l'une quelconque des revendications précédentes, dans lequel l'objet (40) traité au moyen du faisceau laser est une tranche.

**6.** Appareil de traitement au laser avec le miroir polygonal (10) selon l'une quelconque des revendications précédentes, qui comprend en outre un dilatateur de faisceau (210) destiné à agrandir un diamètre en coupe du faisceau laser émis depuis le générateur de laser (140), le faisceau laser agrandi étant condensé sur la lentille (20) après avoir été réfléchi sur le miroir polygonal (10) et étant incident sur le dispositif de transformation de faisceau (220).

**7.** Appareil de traitement au laser avec le miroir polygonal (10) selon la revendication 5, dans lequel la lentille (20) condense le faisceau laser sur celui-ci puis irradie le faisceau laser sur la tranche (40) de manière perpendiculaire.

**8.** Appareil de traitement au laser avec le miroir polygonal (10) selon la revendication 5, dans lequel le dispositif de commande (110) commande une longueur de balayage du faisceau laser appliqué à la tranche (40) au moyen d'un des plans de réflexion (12) conformément à la rotation du miroir polygonal (10) par le produit d'une distance focale de la lentille (20) et d'un angle de balayage du faisceau laser réfléchi depuis les plans de réflexion (12) du miroir polygonal (10).

**9.** Appareil de traitement au laser avec le miroir polygonal (10) selon la revendication 8, dans lequel le dispositif de commande (110) commande l'angle de balayage du faisceau laser de façon à ce qu'il soit un angle de réflexion formé par les parties de début et arrière du plan de réflexion (12).

**10.** Appareil de traitement au laser avec le miroir polygonal (10) selon la revendication 5, dans lequel le faisceau laser réfléchi depuis le plan de réflexion (12) conformément à la rotation du miroir polygonal (10) est irradié sur la tranche (40) qui est chevauchée un nombre prédéterminé de fois et le dispositif de commande (110) commande le nombre prédéterminé de chevauchements par ajustement d'une vitesse angulaire du miroir polygonal (10) tandis qu'une vitesse de transfert de la platine (30) est gardée constante.

**11.** Appareil de traitement au laser avec le miroir polygonal (10) selon la revendication 5, dans lequel le faisceau laser réfléchi depuis le plan de réflexion (12) conformément à la rotation du miroir polygonal (10) est irradié sur la tranche (40) qui est chevauchée un nombre prédéterminé de fois et le dispositif de commande (110) commande le nombre prédéterminé de chevauchements par ajustement d'une vitesse de transfert de la platine (30) tandis qu'une vitesse angulaire du miroir polygonal (10) est gardée constante.

FIG. 1A

Laser beam

FIG. 1B

Laser beam

FIG. 1C

Laser beam

Processing
plane of wafer

S1   S2   S3

SL

FIG. 2

FIG. 3

$S_L$

Uniform overlapping interval

$\ell$

Overlapping
number

Distance

FIG. 4

120    160    170

Input unit    Display Unit    Storage unit

130

Controller    Polygon mirror driver

110

Rotating direction

11

10

12

Reflecting of laser beam

140

Laser generator

Laser beam

20

Condensing

Progressing direction of laser beam

40

30

Transfer direction

Stage transfer unit    150

16

FIG. 5

Stage transfer unit   150

Transfer direction

30

Progressing direction
of laser beam   40

Elliptical
laser beam

220

Condensing

20

Reflecting of
laser beam   12

Rotating
direction

10

11

Beam expander   210

Laser beam expanding
(circular beam)

Laser generator   140

Point laser

Polygon mirror driver   130

Controller   110

Input unit   120

Display Unit   160

Storage unit   170

EP 1 586 406 B1

17

FIG. 6

```
        ( Start )
           |
           v
  +---------------------+
  | Set control parameters |---- S10
  +---------------------+
           |
           v
  +---------------------+
  | Drive polygon mirror |---- S20
  +---------------------+
           |
           v
  +---------------------+
  |   Transfer stage    |---- S30
  +---------------------+
           |
           v
  +---------------------+
  |   Emit laser beam   |---- S40
  +---------------------+
           |
           v
  +---------------------+
  |     Cut wafer       |---- S50
  +---------------------+
           |
           v
        (  End  )
```

FIG. 7

**EP 1 586 406 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5632083 A
- US 20030184835 A1
- US 5254833 A